# EUROPEAN PATENT APPLICATION

(11) **EP 4 687 258 A1**
(43) Date of publication of application: **04.02.2026**
(21) Application number: 25181710.2
(22) Date of filing: 10.06.2025
(51) Int. Cl.: H02J 7/00, G01R 31/396

(54) **BATTERY CELL REPLACEMENT DETECTION APPARATUS AND METHOD**

(30) Priority: 31.07.2024 KR 20240102159
(71) Applicant: Samsung SDI Co., Ltd., Yongin-si, Gyeonggi-do 17084 (KR)
(72) Inventor: CHO, Young Shin, 16678 Suwon-si (KR); PARK, Jong Sam, 16678 Suwon-si (KR); KANG, Kyung Do, 16678 Suwon-si (KR)
(74) Representative: Marks & Clerk LLP

(57) **Abstract**

The present disclosure relates to a battery cell replacement detection apparatus and method, and is directed to providing a mechanism that can prevent the mount of non-genuine batteries in a battery pack by detecting whether the battery cell in the battery pack has been replaced. To achieve this, the present disclosure provides a configuration for detecting whether the battery cell mounted in the battery pack has been replaced by analyzing changes in a unique characteristic parameter, that depends on at least one chemical characteristic of the battery cell, during a process in which the battery cell mounted in the battery pack is charged and discharged.

## Description

### FIELD

The present disclosure relates to an apparatus and method for detecting whether a battery cell in a battery pack has been replaced.

### BACKGROUND

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

The above information disclosed in this Background section is for enhancement of understanding of the background of the present disclosure, and therefore, it may contain information that does not constitute related (or prior) art.

### SUMMARY

To achieve the objects described herein, a battery cell replacement detection apparatus according to some embodiments of the technology described herein may include a processor, and a memory storing at least one command executed by the processor, wherein the processor is configured to detect whether a battery cell mounted in a battery pack has been replaced by analyzing changes in a unique characteristic parameter, that depends on at least one chemical characteristic of the battery cell, during a process in which the battery cell mounted in the battery pack is charged and discharged.

In some embodiments, the unique characteristic parameter is a first curve graph defined by a ratio between a voltage change amount and a capacity change amount of the battery cell during the process in which the battery cell mounted in the battery pack is charged and discharged.

In some embodiments, the processor is configured to detect whether the battery cell mounted in the battery pack has been replaced by analyzing changes in a local extremum of the first curve graph.

In some embodiments, the processor is configured to detect whether the battery cell mounted in the battery pack has been replaced by determining whether a local extremum of a second curve graph obtained at a second time point that is temporally subsequent to a first time point matches a change behavior of the local extremum of the first curve graph derived from a result of analyzing the changes in the unique characteristic parameter during the process of charging and discharging the battery cell up to the first time point.

In some embodiments, the processor is configured to: obtain the first curve graph each time a charging and discharging cycle corresponding to a specific period in a time interval up to the first time point is completed and derive a first change amount for a position of the local extremum of the first curve graph; and determine that the battery cell mounted in the battery pack has been replaced when a difference between the first change amount and a second change amount for a position of the local extremum of the second curve graph compared to the position of the local extremum of the first curve graph obtained last in the time interval up to the first time point is greater than or equal to a predefined threshold value.

In some embodiments, the local extremum includes a peak of the first curve graph, and the processor is configured to: derive a horizontal axis position change amount and a vertical axis position change amount of the peak of the first curve graph as the first change amount based on a coordinate system in which the first curve graph is defined; derive a horizontal axis position change amount and a vertical axis position change amount of a peak of the second curve graph compared to the peak of the first curve graph obtained last in the time interval up to the first time point as the second change amount; and determine that the battery cell mounted in the battery pack has been replaced when a difference between the horizontal axis position change amount of the first change amount and the horizontal axis position change amount of the second change amount is greater than or equal to a first threshold value or when a difference between the vertical axis position change amount of the first change amount and the vertical axis position change amount of the second change amount is greater than or equal to a second threshold value.

In some embodiments, the processor is configured to: obtain the first curve graph each time a charging and discharging cycle corresponding to a specific period in a time interval up to the first time point is completed and derive a third change amount for an interval of the local extremum of the first curve graph; and determine that the battery cell mounted in the battery pack has been replaced when a difference between the third change amount and a fourth change amount for an interval of the local extremum of the second curve graph compared to the interval of the local extremum of the first curve graph obtained last in the time interval up to the first time point is greater than or equal to a predefined threshold value.

In some embodiments, the local extremum includes a trough of the first curve graph, and the processor is configured to: derive an interval change amount of a trough of the first curve graph as the third change amount based on a coordinate system in which the first curve graph is defined; derive an interval change amount of a trough of the second curve graph compared to the trough of the first curve graph obtained last in the time interval up to the first time point as the fourth change amount; and determine that the battery cell mounted in the battery pack has been replaced when a difference between the interval change amount of the third change amount and the interval change amount of the fourth change amount is greater than or equal to the threshold value.

In some embodiments, the local extremum includes a peak or trough of the first curve graph, and the processor is configured to determine that the battery cell mounted in the battery pack has been replaced when a number of peaks of the first curve graph is not equal to a number of peaks of the second curve graph or when a number of troughs of the first curve graph is not equal to a number of troughs of the second curve graph.

In some embodiments, the processor is configured to: store the change behavior of the local extremum of the first curve graph in the memory for each temperature section of the battery cell; and extract the change behavior of the local extremum of the first curve graph corresponding to a current temperature of the battery cell from the memory during an operation for detecting whether the battery cell mounted in the battery pack has been replaced and detect whether the battery cell mounted in the battery pack has been replaced using the extracted change behavior of the local extremum of the first curve graph.

In some embodiments, the first time point required for deriving the change behavior of the local extremum of the first curve graph is a time point after the battery cell has been subjected to a predefined number of charging and discharging cycles.

In some embodiments, the first curve graph is an incremental capacity curve according to an incremental capacity analysis (ICA) or a differential voltage curve according to a differential voltage analysis (DVA).

In some embodiments, the processor is configured to enter a use prohibition mode that prohibits the use of the battery pack when it is determined that the battery cell mounted in the battery pack has been replaced.

In some embodiments, the processor is configured to enter a detection stop mode in which an operation for detecting whether the battery cell mounted in the battery pack has been replaced is not performed when a first flag signal is received and to release the detection stop mode when a second flag signal having a complementary value to the first flag signal is received.

According to some aspects, there is provided a battery cell replacement detection method which may comprise performing, by a processor, charging and discharging of a battery cell mounted in a battery pack; and detecting, by the processor, whether the battery cell mounted in the battery pack has been replaced by analyzing changes in a unique characteristic parameter, that depends on at least one chemical characteristic of the battery cell, during a process in which the battery cell mounted in the battery pack is charged and discharged.

In some embodiments, the unique characteristic parameter is a first curve graph defined by a ratio between a voltage change amount and a capacity change amount of the battery cell during the process in which the battery cell mounted in the battery pack is charged and discharged, and in the detecting, the processor detects whether the battery cell mounted in the battery pack has been replaced by analyzing changes in a local extremum of the first curve graph.

In some embodiments, in the detecting, the processor is configured to detect whether the battery cell mounted in the battery pack has been replaced by determining whether a local extremum of a second curve graph obtained at a second time point that is temporally subsequent to a first time point matches a change behavior of the local extremum of the first curve graph derived from a result of analyzing the changes in the unique characteristic parameter during the process of charging and discharging the battery cell up to the first time point.

In some embodiments, the local extremum includes a peak of the first curve graph; and in the detecting, the processor is configured to: obtain the first curve graph each time a charging and discharging cycle corresponding to a specific period in a time interval up to the first time point is completed and derive a first change amount for a position of the local extremum of the first curve graph; and determine that the battery cell mounted in the battery pack has been replaced when a difference between the first change amount and a second change amount for a position of the local extremum of the second curve graph compared to the position of the local extremum of the first curve graph obtained last in the time interval up to the first time point is greater than or equal to a predefined threshold value.

In some embodiments, the local extremum includes a trough of the first curve graph; and in the detecting, the processor is configured to: obtain the first curve graph each time a charging and discharging cycle corresponding to a specific period in a time interval up to the first time point is completed and derive a third change amount for an interval of the local extremum of the first curve graph: and determine that the battery cell mounted in the battery pack has been replaced when a difference between the third change amount and a fourth change amount for an interval of the local extremum of the second curve graph compared to the interval of the local extremum of the first curve graph obtained last in the time interval up to the first time point is greater than or equal to a predefined threshold value.

In some embodiments, the local extremum includes a peak or trough of the first curve graph; and in the detecting, the processor is configured to determine that the battery cell mounted in the battery pack has been replaced when a number of peaks of the first curve graph is not equal to a number of peaks of the second curve graph or when a number of troughs of the first curve graph is not equal to a number of troughs of the second curve graph.

At least some of the above and other features of the invention are set out in the claims.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings, in which:
FIG. 1 shows a block diagram of a battery cell replacement detection apparatus according to some embodiments of the technology described herein;
FIGS. 2A to 2D show a charging method of a battery cell in the battery cell replacement detection apparatus according to some embodiments of the technology described herein;
FIGS. 3A and 3B show examples of an incremental capacity curve in the battery cell replacement detection apparatus according to some embodiments of the technology described herein;
FIGS. 4A and 4B show examples of a differential voltage curve in the battery cell replacement detection apparatus according to some embodiments of the technology described herein; and
FIGS. 5 to 7 show flowcharts of a battery cell replacement detection method according to some embodiments of the technology described herein.

### DETAILED DESCRIPTION

Hereinafter, embodiments of the present disclosure will be described, in detail, with reference to the accompanying drawings. The terms or words used in this specification and claims should not be construed as being limited to the usual or dictionary meanings and should be interpreted as meanings and concepts consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the drawings, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

Users of products such as vacuum cleaners, mobile phones, or laptops frequently purchase non-genuine batteries (so-called counterfeit batteries) and mount them in the products due to the lower price of such batteries.

However, since the non-genuine batteries (which may also be referred to as unauthorized batteries or uncertified batteries) do not have a stabilization circuit or only partially include the stabilization circuit to stably drive various circuits that constitute a battery pack, there is a risk of explosion due to overheating and in addition, there is a problem of product failure due to the inability to stably supply operating power to the product.

In order to prevent the use of such non-genuine batteries and promote the use of genuine batteries, a genuine authentication function via communication has been introduced. However, in order to pass the genuine authentication function, cases in which private vendors replace only battery cells while keeping a battery management system printed circuit board (BMS PCB) of the battery pack intact and selling them are increasing, and when the battery pack is woken up after the battery cells are replaced while the battery pack is shut down, a battery management system (BMS) applied to the battery pack may not detect whether the battery cells have been replaced. Therefore, there is still the risk of explosion due to overheating of the battery pack and the problem of product failure due to unstable operating power.

The technology described herein intends to achieve the above-described objects and is directed to providing a battery cell replacement detection apparatus and method that detects whether the battery cell in the battery pack has been replaced and determines whether to prevent the use of the battery pack based on the detection result to prevent a non-genuine battery from being installed in the battery pack.

However, objects that the technology described herein intends to achieve are not limited to the above-described objects and other objects that are not described may be clearly understood by those skilled in the art from the following description.

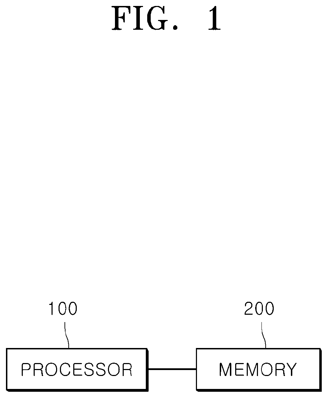

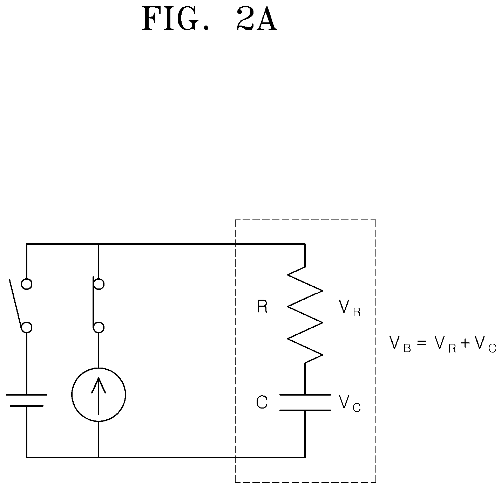

FIG. 1 is a block diagram of a battery cell replacement detection apparatus according to some embodiments of the technology described herein, FIGS. 2A to 2D are example diagrams showing a charging method of a battery cell in the battery cell replacement detection apparatus according to some embodiments of the technology described herein,

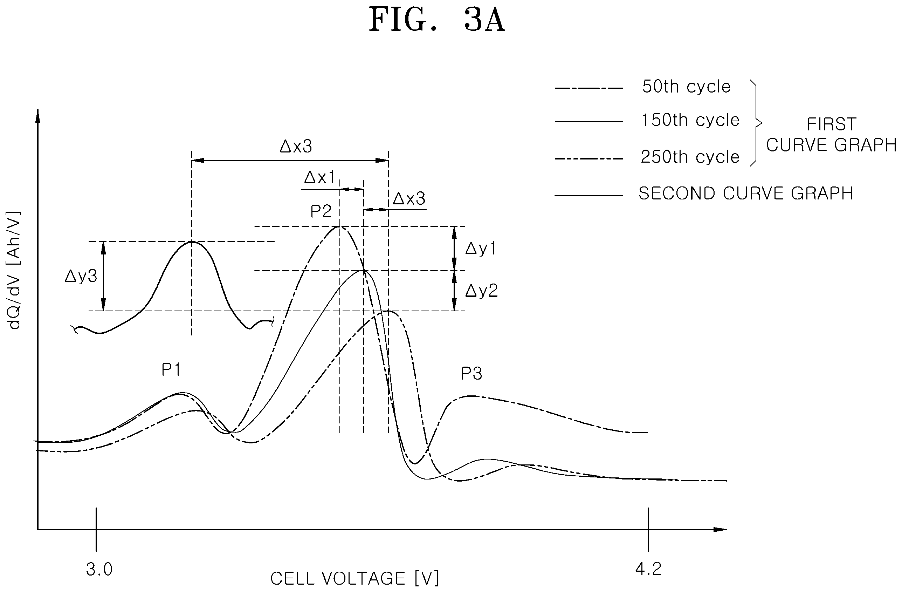

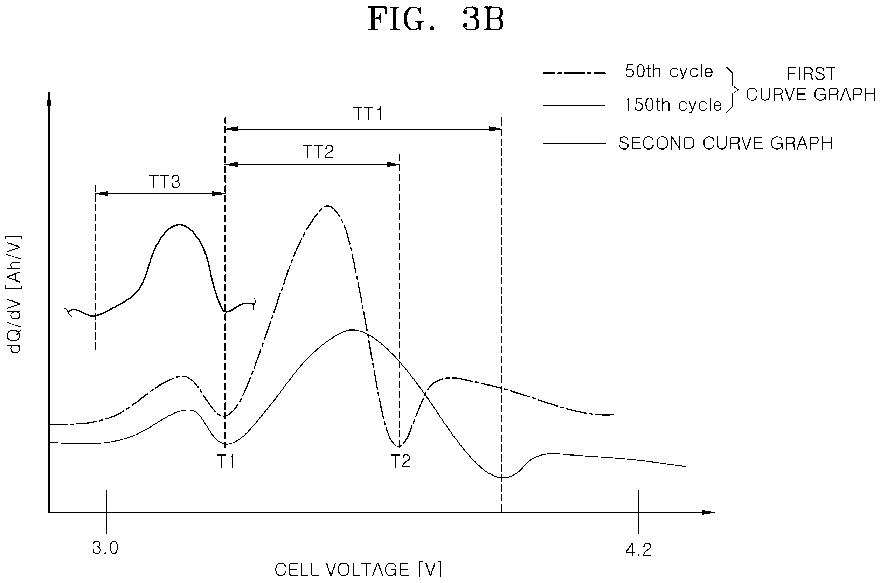

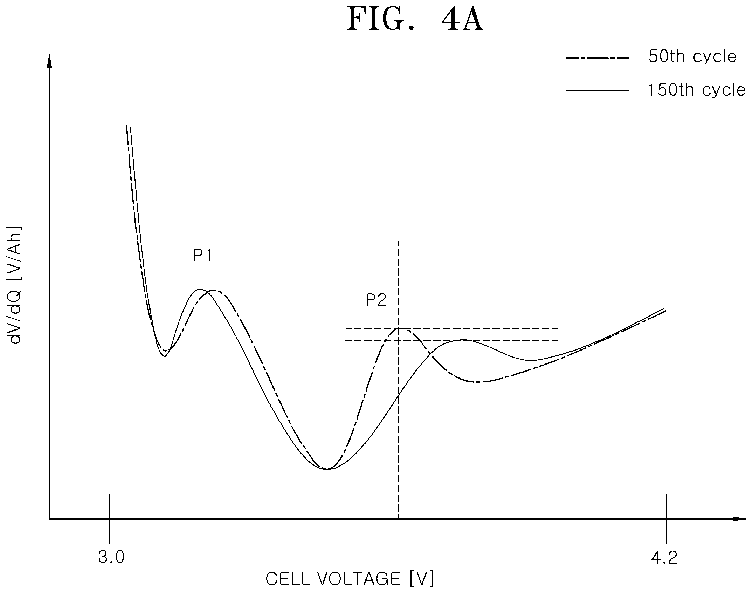

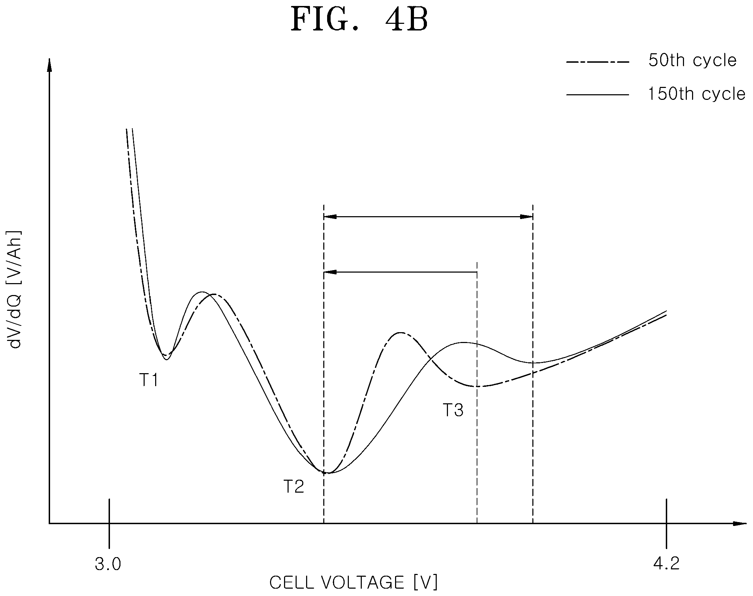

FIGS. 3A and 3B are example diagrams of an incremental capacity curve in the battery cell replacement detection apparatus according to some embodiments of the technology described herein, and FIGS. 4A and 4B are example diagrams of a differential voltage curve in the battery cell replacement detection apparatus according to some embodiments of the technology described herein.

Referring to FIG. 1, the battery cell replacement detection apparatus according to the present embodiment may include a processor 100 and a memory 200.

The processor 100 is an object that detects whether a battery cell in a battery pack has been replaced, may be implemented as a central processing unit (CPU) or a system on chip (SoC), may control a plurality of hardware or software components connected to the processor 100 by driving an operating system or an application, and may perform various types of data processing and calculations. The processor 100 may be configured to execute at least one command stored in the memory 200 and may store the execution result data in the memory 200.

In the present embodiment, the processor 100 may be implemented as a battery management system (BMS) provided in the battery pack or as a micro controller unit (MCU) in the BMS, and as is well known, may be configured to detect a battery state such as a current, a voltage, an open circuit voltage (OCV), and/or a temperature of the battery cell. Data about the battery state detected by the processor 100 may be written to the memory 200 and read or erased from the memory 200 as needed.

The memory 200 may store at least one command executed by the processor 100. The memory 200 may be implemented as a volatile storage medium and/or a non-volatile storage medium (e.g., at least one non-transitory computer-readable storage medium having instructions encoded thereon, that when executed by the processor, cause the processor to perform any of the methods described herein), and may be implemented as, for example, a read only memory (ROM), a random access memory (RAM), a flash memory, or an electrically erasable programmable read-only memory (EEPROM).

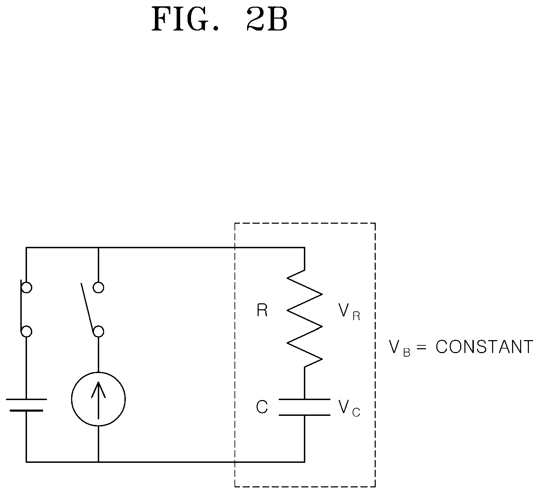

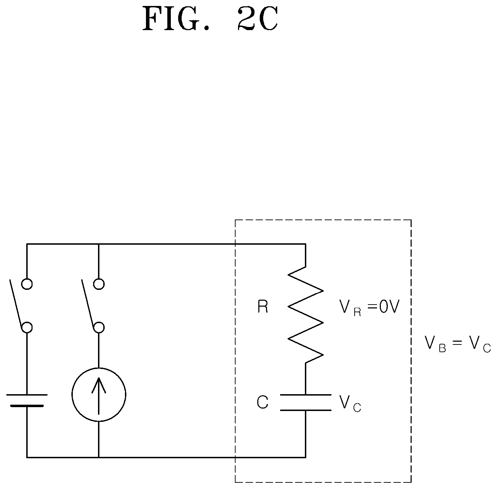

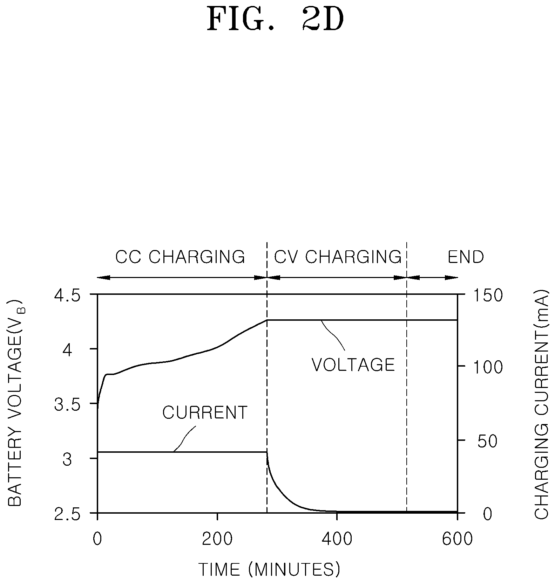

The processor 100 may operate to detect whether a battery cell in the battery pack, which are focused on in the present embodiment, has been replaced by executing the command stored in the memory 200. This battery cell replacement detection operation is based on analyzing a unique characteristic parameter (described herein) of the battery cell during a charging and discharging process of the battery cell mounted in the battery pack. A constant current/constant voltage (CC/CV) method that is a charging method applied to the charging and discharging of the battery cell is described with reference to FIG. 2 as follows.

The CC/CV charging method is a charging method in which CC charging (i.e., constant current charging) is performed until a battery voltage (a battery cell voltage or a battery module voltage) reaches a preset voltage and then CV charging (i.e., constant voltage charging) is performed until a charging current reaches a preset termination current value. While CC charging is performed, as shown in FIG. 2A, since a switch of a constant current power supply is turned on and a switch of a constant voltage power supply is turned off, a constant current is applied to a battery. During the period in which CC charging is performed, since a constant current (I) is applied to the battery cell, a voltage V_{R} formed across an internal resistor R has a constant value according to Ohm's law (V_{R} = I × R), a voltage V_{C} formed across a capacitor C of the battery increases, and the battery voltage V_{B} increases accordingly.

When the battery voltage V_{B} reaches a preset voltage (4.3[V] in the example of FIG. 2D), the charging method switches from CC charging to CV charging. While CV charging is performed, as shown in FIG. 2B, since the switch of the constant voltage power supply is turned on and the switch of the constant current power supply is turned off, the battery voltage V_{B} has a constant magnitude. Meanwhile, a voltage of the capacitor C of the battery increases, and since the equation " V_{B} = V_{R} + V_{C}" should be satisfied, the voltage V_{R} formed across the internal resistor R decreases. As the voltage V_{R} formed across the internal resistor R decreases, the current (I) flowing in the battery also decreases according to Ohm's law (V_{R} = I × R).

When the current (I) flowing in the battery reaches a preset termination current (0.01[mA] in the example of FIG. 2D), CV charging ends. When CV charging ends, as shown in FIG. 2C, since the switches of both the constant current power supply and the constant voltage power supply are turned off, the current (I) flowing in the battery becomes 0[A], and accordingly, the voltage V_{R} formed across the internal resistor R also becomes 0[V]. However, since the voltage V_{R} formed across the internal resistor R decreases sufficiently during the CV charging process, even when no further drop in the voltage V_{R} formed across the internal resistor R occurs, no significant drop in the battery voltage V_{B} occurs.

A charging cycle of the battery performed through the above-described process and a discharging cycle of the battery for driving a load may constitute one charging and discharging cycle. The processor 100 of the present embodiment may operate to detect whether a battery cell in the battery pack has been replaced by analyzing changes in a unique characteristic parameter, wherein the unique characteristic parameter depends on the chemical characteristics of the battery cell, in a process in which the charging and discharging cycles of the battery cell mounted in the battery pack are performed. Hereinafter, a process of detecting whether the battery cell has been replaced will be described in detail.

As described above, the processor 100 may analyze the changes in the unique characteristic parameter, which depend on the chemical characteristics of the battery cell. The unique characteristic parameter may thus be expected to differ between different cells. In particular, it may be expected to differ between a genuine cell and a non-genuine cell. The chemical characteristics of the battery cell may refer to the chemical characteristics of a negative electrode active material (e.g., graphite, carbon, etc.) or a positive electrode active material (e.g., a transition metal oxide such as LiCoO₂, LiNiO₂, or LiMn₂O₄) of the battery cell. In addition, the unique characteristic parameters may refer to a curve graph defined by a ratio between a voltage change amount and a capacity change amount of the battery cell, and may correspond to, for example, an incremental capacity curve according to an incremental capacity analysis (ICA, dQ/dV) as shown in FIG. 3 or a differential voltage curve according to a differential voltage analysis (DVA, dV/dQ) as shown in FIG. 4.

That is, based on the fact that a pattern (i.e. a shape or distribution) of the incremental capacity curve (dQ/dV) of the battery cell varies depending on the active material of the battery cell and similarly, a pattern (i.e. a shape or distribution) of the differential voltage curve (dV/dQ) of the battery cell also varies depending on the active material of the battery cell, the present embodiment adopts a configuration that detects whether the battery cell has been replaced by analyzing changes in the incremental capacity curve or the differential voltage curve of the battery cell (hereinafter, the curve graph refers to the incremental capacity curve or the differential voltage curve).

As a method of analyzing changes in the curve graph, a method of analyzing changes in a local extremum of the curve graph may be adopted. Specifically, the processor 100 may detect whether the battery cell in the battery pack has been replaced by determining whether the local extremum of the curve graph (defined as a second curve graph) obtained at a second time point that is temporally subsequent to a first time point matches a change behavior of the local extremum of the curve graph (defined as the first curve graph) derived from a result of analyzing the changes in the unique characteristic parameter in a process of charging and discharging the battery cell up to the first time point.

That is, the processor 100 may store the change behavior of the local extremum of the first curve graph as reference data in the memory 200 when the charging and discharging of the battery cell proceeds in a state in which a genuine battery cell is mounted in the battery pack, and may determine whether the local extremum of the second curve graph matches the change behavior of the local extremum of the first curve graph stored as reference data in the memory 200 when the charging and discharging of the battery cell proceeds at a later point in time. When the local extremum of the second curve graph does not match the change behavior of the local extremum of the first curve graph, the processor 100 may determine that the battery cell currently mounted in the battery pack is a non-genuine battery cell and operate to enter a use prohibition mode that prohibits the use of the battery pack.

To obtain the change behavior of the first curve graph, which serves as reference data, the charging and discharging of the battery cell may need proceed for a predetermined time after the battery pack is first manufactured. **In** the present embodiment, a time from a time point when the battery pack is first used to a first time point is defined as the time required for deriving the change behavior of the local extremum of the first curve graph. Specifically, the first time point required for deriving the change behavior of the local extremum of the first curve graph may correspond to a time point after the battery cell has been subjected to a predefined number of charging and discharging cycles. The predefined number of charging and discharging cycles may be stored as, for example, 50 cycles, in the memory 200, and accordingly, the processor 100 may not perform an operation for detecting whether the battery cell has been replaced until the charging and discharging cycles of the battery cell reach 50 cycles from the time point when the battery pack is first used. During a time period from the time point when the battery pack is first used until the charging and discharging cycles of the battery cell reach 50 cycles (i.e., during a time period from the time point when the battery pack is first used up to the first time point), the processor 100 may operate to quantify the change behavior of the local extremum of the first curve graph and store the quantified change behavior in the memory 200. Once the charging and discharging cycles of the battery cell reach 50 cycles, the processor 100 may initiate the operation for detecting whether the battery cell has been replaced using the change behavior of the local extremum of the first curve graph stored in the memory 200 as reference data.

A quantitative example of 'a configuration for detecting whether the battery cell has been replaced by analyzing the changes in the local extremum of the curve graph is described.

As shown in FIG. 3, the local extrema of the curve graph (the incremental capacity curve) may include peaks and troughs, and first, a case in which a local extremum corresponds to a peak is described.

The processor 100 may obtain the first curve graph each time a charging and discharging cycle corresponding to a specific period in the time interval up to the first time point is completed and derive a first change amount for the peak position of the first curve graph. FIG. 3A shows an example in which the specific period corresponds to 100 cycles and three first curve graphs are obtained at the 50th, 150th, and 250th charging and discharging cycles in the time interval up to the first time point. In the example of FIG. 3A, each of the first curve graphs has first to third peaks P1, P2, and P3, and any one of the peaks may be used to derive the first change amount (FIG. 3A shows an example in which the second peak is used to derive the first change amount).

The first change amount may include a horizontal axis position change amount and a vertical axis position change amount of the peak of the first curve graph based on a coordinate system in which the first curve graph is defined. FIG. 3A shows an example of a coordinate system in which the cell voltage is on a horizontal axis and a ratio between a capacity change amount and a voltage change amount (dQ/dV) of the battery cell is on a vertical axis. However, the horizontal axis of the coordinate system may be set to not only the cell voltage but also a state of charge (SOC), a depth of discharge (DOD), and/or an integrated capacity of the battery cell. In the example of FIG. 3A, the horizontal axis position change amount of the peak of the first curve graph may be determined as an average value of two horizontal axis position change amounts △x1 and △x2 for the second peak, and the vertical axis position change amount of the peak of the first curve graph may be determined as an average value of two vertical axis position change amounts △y1and △y2 for the second peak.

Subsequently, at the second time point that is temporally subsequent to the first time point, the processor 100 may obtain the second curve graph of the battery cell during the charging and discharging cycles of the battery cell, and may derive, as a second change amount, a horizontal axis position change amount (△x3 in FIG. 3A) and a vertical axis position change amount (△y3 in FIG. 3A) of the peak of the second curve graph compared to the peak of the first curve graph that is obtained last in the time interval up to the first time point (i.e., the first curve graph corresponding to the 250th charging and discharging cycle in FIG. 3A).

When the first and second change amounts are derived, the processor 100 may detect whether the battery cell in the battery pack has been replaced by comparing the first and second change amounts. In this case, when a difference between the horizontal axis position change amount of the first change amount and the horizontal axis position change amount of the second change amount is greater than or equal to a predefined first threshold value or when a difference between the vertical axis position change amount of the first change amount and the vertical axis position change amount of the second change amount is greater than or equal to a predefined second threshold value, the processor 100 may determine that the battery cell in the battery pack has been replaced. That is, when a difference between the horizontal axis position change amount of the first change amount that is associated with the unique characteristic of a normal battery cell and the horizontal axis position change amount of the second change amount that is associated with the unique characteristic of the battery cell currently mounted in the battery pack is greater than or equal to the first threshold value, since the unique characteristic of the battery cell currently mounted in the battery pack does not match the unique characteristic of the normal battery cell, in this case, the processor 100 may determine that the battery cell in the battery pack has been replaced. Likewise, when a difference between the vertical axis position change amount of the first change amount that is associated with the unique characteristic of the normal battery cell and the vertical axis position change amount of the second change amount that is associated with the unique characteristic of the battery cell currently mounted in the battery pack is greater than or equal to the second threshold value, since the unique characteristic of the battery cell currently mounted in the battery pack does not match the unique characteristic of the normal battery cell, in this case, the processor 100 may determine that the battery cell in the battery pack has been replaced.

Next, a case in which the local extremum corresponds to a trough is described.

The processor 100 may obtain the first curve graph each time the charging and discharging cycle corresponding to a specific period in the time interval up to the first time point is completed and derive a third change amount for an interval of the local extrema of the first curve graph. FIG. 3B shows an example in which the above-described specific period corresponds to 100 cycles and two first curve graphs are obtained at the 50th and 150th charging and discharging cycles in the time interval up to the first time point (unlike FIG. 3A, only two first curve graphs are shown in FIG. 3B to help understand the embodiment). In the example of FIG. 3B, each first curve graph has first and second troughs T1 and T2.

The third change amount may include a change amount (based on the horizontal axis) in the interval of troughs of the first curve graph based on the coordinate system in which the first curve graph is defined. FIG. 3B shows an example of a coordinate system in which the cell voltage is on a horizontal axis and a ratio between a capacity change amount and a voltage change amount (dQ/dV) of the battery cell is on a vertical axis. However, the horizontal axis of the coordinate system may be set to not only the cell voltage but also a state of charge (SOC), a depth of discharge (DOD), or an integrated capacity of the battery cell. In the example of FIG. 3B, a difference between the interval TT1 of troughs of the first curve graph corresponding to the 50th charging and discharging cycle and the interval TT2 of troughs of the first curve graph corresponding to the 150th charging and discharging cycle may be determined as the third change amount, that is, a change amount in the interval of the troughs of the first curve graph (i.e., TT2 - TT1).

Subsequently, at the second time point that is temporally subsequent to the first time point, the processor 100 may obtain the second curve graph of the battery cell during the charging and discharging cycles of the battery cell, and may derive a change amount in the interval of the troughs of the second curve graph compared to the troughs of the first curve graph that is obtained last in the time interval up to the first time point (i.e., the first curve graph corresponding to the 150th charging and discharging cycle in FIG. 3B), as a fourth change amount (i.e., TT3 - TT2) (when the fourth change amount has a negative value, the absolute value may be applied).

When the third and fourth change amounts are derived, the processor 100 may detect whether the battery cell in the battery pack has been replaced by comparing the third and fourth change amounts. In this case, when a difference between the interval change amount of the third change amount and the interval change amount of the fourth change amount is greater than or equal to a predefined threshold value, the processor 100 may determine that the battery cell in the battery pack has been replaced. That is, when a difference between the interval change amount of the third change amount that is associated with the unique characteristic of the normal battery cell and the interval change amount of the fourth change amount that is associated with the unique characteristic of the battery cell currently mounted in the battery pack is greater than or equal to the threshold value, since the unique characteristic of the battery cell currently mounted in the battery pack does not match the unique characteristic of the normal battery cell, in this case, the processor 100 may determine that the battery cell in the battery pack has been replaced.

Independently of the operation that detects whether the battery cell has been replaced according to the above-described first to fourth change amounts, the processor 100 may also determine that the battery cell in the battery pack has been replaced when the number of peaks in the first curve graph is not equal to the number of peaks in the second curve graph, or when the number of troughs in the first curve graph is not equal to the number of troughs in the second curve graph. That is, when the number of local extrema in the first curve graph is not equal to the number of local extrema in the second curve graph, since the chemical characteristics of the battery cell that are derived from the first curve graph do not match the chemical characteristics of the battery cell that are derived from the second curve graph, this indicates that the battery cells at each time point are different, and in this case, the processor 100 may determine that the battery cell in the battery pack has been replaced. Furthermore, an embodiment may be provided in which the operation that detects whether the battery cell has been replaced according to the above-described first to fourth change amounts is performed only when it is determined that the number of peaks in the first curve graph matches the number of peaks in the second curve graph and the number of troughs in the first curve graph matches the number of troughs in the second curve graph.

Meanwhile, since the incremental capacity curve shown in FIG. 3 has different patterns depending on the temperature of the battery cell during the charging and discharging cycles, the battery cell replacement detection operation using the first and second curve graphs should be based on the assumption that the battery cells have the same temperature. To this end, the processor 100 may operate to store the change behavior of the local extremum of the first curve graph in the memory 200 for each temperature section of the battery cell. Based on this, the processor 100 may extract the change behavior of the local extrema of the first curve graph corresponding to a current temperature of the battery cell from the memory during an operation for detecting whether the battery cell in the battery pack has been replaced and detect whether the battery cell in the battery pack has been replaced using the extracted change behavior of the local extrema of the first curve graph.

The above-described configuration may be applied not only to the incremental capacity curve of FIG. 3 but also to the differential voltage curves of FIGS. 4A and 4B.

In addition, there may be exceptional cases in which the operation for detecting whether the battery cell has been replaced should not be performed, such as a case in which the battery cell is replaced for repairing the battery pack or a case in which the BMS is mounted in another battery pack for reuse of the BMS. In this case, the operator may transmit a flag signal instructing whether to perform the operation for detecting whether the battery cell has been replaced to the processor 100 through an external device. Accordingly, the processor 100 may be configured to enter a detection stop mode in which the operation for detecting whether the battery cell in the battery pack has been replaced is not performed when a first flag signal is received and to release the detection stop mode when a second flag signal having a complementary value to the first flag signal is received.

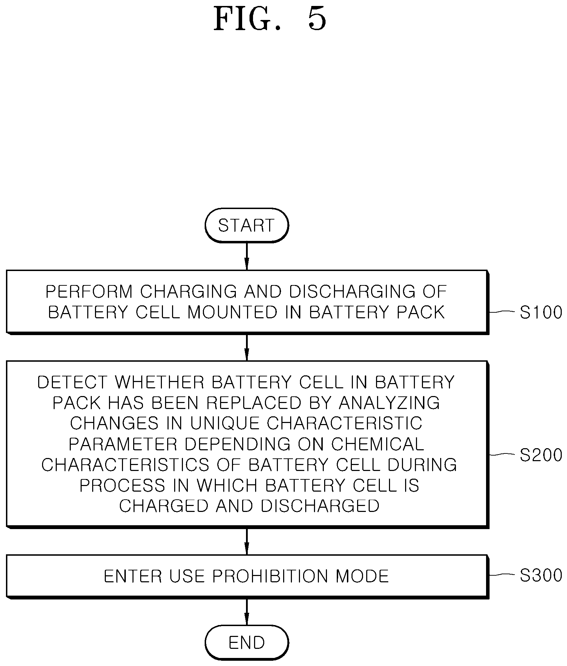

FIGS. 5 to 7 show flowcharts of a battery cell replacement detection method according to some embodiments of the technology described herein. The battery cell replacement detection method according to the present embodiment will be described with reference to FIGS. 5 to 7, and a detailed description of the configuration that overlaps the above-described content will be omitted and the description will focus on a time-series configuration.

First, a processor 100 performs charging and discharging of a battery cell mounted in a battery pack (S100).

Subsequently, the processor 100 detects whether the battery cell in the battery pack has been replaced by analyzing changes in a unique characteristic parameter depending on chemical characteristics of the battery cell during a process of charging and discharging the battery cell. (S200).

**In** operation S200, the processor 100 detects whether the battery cell in the battery pack has been replaced by analyzing changes in the local extrema of the curve graph, and specifically, detects whether the battery cell in the battery pack has been replaced by determining whether a local extremum of a second curve graph obtained at a second time point that is temporally subsequent to a first time point matches a change behavior of a local extremum of a first curve graph derived from a result of analyzing the changes in the unique characteristic parameter during a process of charging and discharging the battery cell up to the first time point. The first time point may be associated with the time required for deriving the change behavior of the local extremum of the first curve graph and may be a time point after the battery cell has been subjected to a predefined number of charging and discharging cycles.

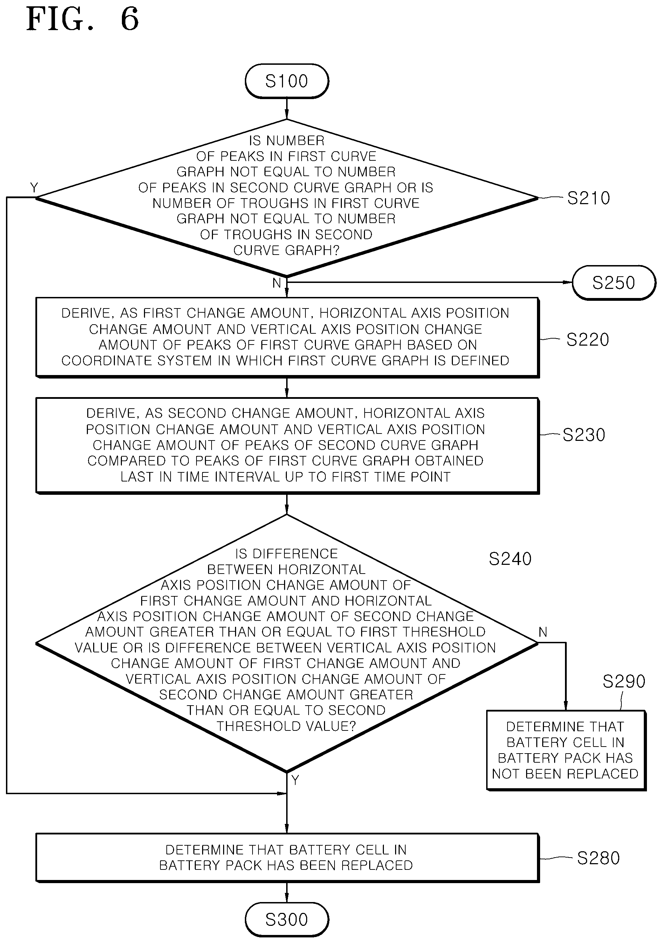

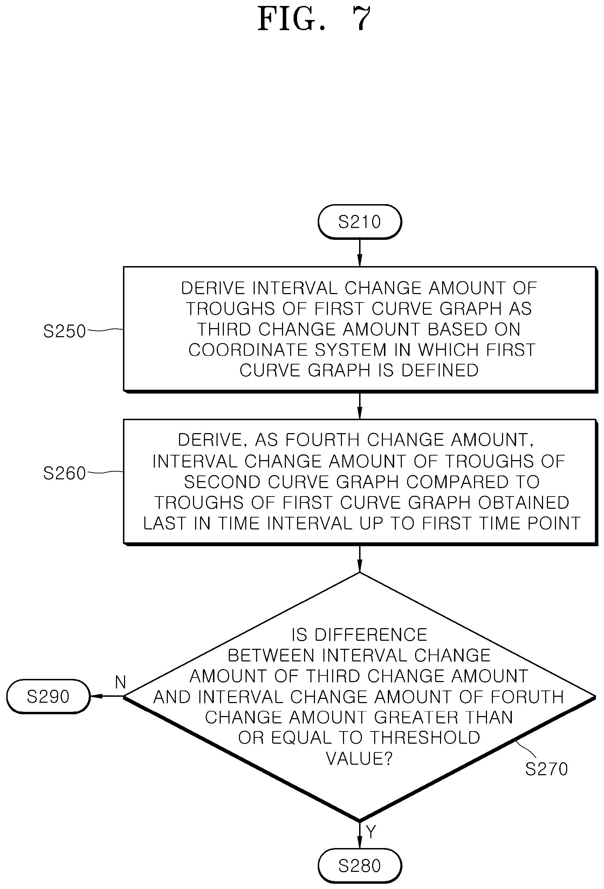

FIGS. 6 and 7 show specific embodiments of operation S200.

Referring to FIG. 6, the processor 100 first determines that the battery cell in the battery pack has been replaced (S280) when the number of peaks in the first curve graph is not equal to the number of peaks in the second curve graph or when the number of troughs in the first curve graph is not equal to the number of troughs in the second curve graph (S210).

The processor 100 derives, as a first change amount, a horizontal axis position change amount and a vertical axis position change amount of peaks of the first curve graph based on a coordinate system in which the first curve graph is defined (S220) when it is determined that the number of peaks in the first curve graph is equal to the number of peaks in the second curve graph and the number of troughs in the first curve graph is equal to the number of troughs in the second curve graph in operation S210.

Subsequently, the processor 100 derives, as a second change amount, a horizontal axis position change amount and a vertical axis position change amount of peaks of the second curve graph compared to the peaks of the first curve graph obtained last at the time interval up to the first time point (S230).

The processor 100 determines that the battery cell in the battery pack has been replaced (S280) when a difference between the horizontal axis position change amount of the first change amount and the horizontal axis position change amount of the second change amount is greater than or equal to a first threshold value, or when a difference between the vertical axis position change amount of the first change amount and the vertical axis position change amount of the second change amount is greater than or equal to a second threshold value (S240).

Thereafter, referring to FIG. 7, the processor 100 derives an interval change amount of troughs of the first curve graph as a third change amount based on the coordinate system in which the first curve graph is defined (S250) when it is determined that the number of peaks in the first curve graph is equal to the number of peaks in the second curve graph and the number of troughs in the first curve graph is equal to the number of troughs in the second curve graph in operation S210.

Subsequently, the processor 100 derives, as a fourth change amount, an interval change amount of troughs of the second curve graph compared to the troughs of the first curve graph obtained last in the time interval up to the first time point (S260).

When a difference between the interval change amount of the third change amount and the interval change amount of the fourth change amount is greater than or equal to a threshold value (S270), the processor 100 determines that the battery cell in the battery pack has been replaced (S280).

Meanwhile, when it is determined that the difference between the horizontal axis position change amount of the first change amount and the horizontal axis position change amount of the second change amount is less than the first threshold value and the difference between the vertical axis position change amount of the first change amount and the vertical axis position change amount of the second change amount is less than the second threshold value in operation S240, or when it is determined that the difference between the interval change amount of the third change amount and the interval change amount of the fourth change amount is less than the threshold value in operation S270, the processor 100 determines that the battery cell in the battery pack has not been replaced (S290).

Operations S220 to S240 in FIG. 6 and operations S250 to S270 in FIG. 7 correspond to independent operations, and an execution order thereof is not limited to the above-described order.

The processor 100 enters a use prohibition mode that prohibits the use of the battery pack (S300) when it is detected that the battery cell has been replaced through operation S280.

Meanwhile, an embodiment may be provided in which conditions are formed so that a detection stop mode in which operation S200 may not be performed is entered when a first flag signal is transmitted to the processor 100 through an external device, and the detection stop mode is released and operation S200 may be performed when a second flag signal having a complementary value to the first flag signal is transmitted to the processor 100.

**In** addition, in operation S200, the processor 100 may store the change behavior of the local extremum of the first curve graph in the memory 200 for each temperature section of the battery cell, extract the change behavior of the local extrema of the first curve graph corresponding to a current temperature of the battery cell from the memory 200 during the operation for detecting whether the battery cell in the battery pack has been replaced and detect whether the battery cell in the battery pack has been replaced using the extracted change behavior of the local extrema of the first curve graph.

According to the technology described herein, by detecting whether the battery cell in the battery pack has been replaced in the manner of analyzing the changes in the unique characteristic parameter (that is, the incremental capacity curve according to the incremental capacity analysis (ICA) or the differential voltage curve according to the differential voltage analysis (DVA)) depending on the chemical characteristics of the active material applied to the battery cell, it is possible to accurately detect a state in which a new battery cell or a different battery cell is mounted in the battery pack, thereby preventing, in advance, overheating and explosion of the battery pack and product failure due to the use of non-genuine batteries.

The embodiments described herein may be implemented, for example, as a method or process, a device, a software program, a data stream, or a signal. Although discussed in the context of a single type of implementation (for example, discussed as a method), features discussed herein may also be implemented in other forms (for example, a device or a program). The device may be implemented by suitable hardware, software (e.g., at least one non-transitory computer-readable storage medium having instructions encoded thereon that, when executed by at least one processor, cause the at least one processor to perform any of the methods described herein), firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

According to the technology described herein, by detecting whether a battery cell in a battery pack has been replaced in a manner of analyzing changes in an unique characteristic parameter (that is, an incremental capacity curve according to an incremental capacity analysis (ICA) or a differential voltage curve according to a differential voltage analysis (DVA)) depending on chemical characteristics of an active material applied to the battery cell, it is possible to accurately detect a state in which a new battery cell or a different battery cell is mounted in the battery pack, thereby preventing, in advance, overheating and/or explosion of the battery pack and/or product failure due to the use of non-genuine batteries.

However, effects that can be achieved through the technology described herein are not limited to the above-described effects and other effects that are not described may be clearly understood by those skilled in the art from the detailed descriptions.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure as set out in the claims and their equivalents, below.

Embodiments are set out in the following clauses:
1. A battery cell replacement detection apparatus, comprising:
   a processor; and
   a memory configured to store at least one command executed by the processor,
   wherein the processor is configured to detect whether a battery cell mounted in a battery pack has been replaced by analyzing changes in a unique characteristic parameter, that depends on at least one chemical characteristic of the battery cell, during a process in which the battery cell mounted in the battery pack is charged and discharged.
2. The battery cell replacement detection apparatus of clause 1, wherein the unique characteristic parameter is a first curve graph defined by a ratio between a voltage change amount and a capacity change amount of the battery cell during the process in which the battery cell mounted in the battery pack is charged and discharged.
3. The battery cell replacement detection apparatus of clause 2, wherein the processor is configured to detect whether the battery cell mounted in the battery pack has been replaced by analyzing changes in a local extremum of the first curve graph.
4. The battery cell replacement detection apparatus of clause 3, wherein the processor is configured to detect whether the battery cell mounted in the battery pack has been replaced by determining whether a local extremum of a second curve graph obtained at a second time point that is temporally subsequent to a first time point matches a change behavior of the local extremum of the first curve graph derived from a result of analyzing the changes in the unique characteristic parameter during the process of charging and discharging the battery cell up to the first time point.
5. The battery cell replacement detection apparatus of clause 4, wherein the processor is configured to:
   obtain the first curve graph each time a charging and discharging cycle corresponding to a specific period in a time interval up to the first time point is completed and derive a first change amount for a position of the local extremum of the first curve graph; and
   determine that the battery cell mounted in the battery pack has been replaced when a difference between the first change amount and a second change amount for a position of the local extremum of the second curve graph compared to the position of the local extremum of the first curve graph obtained last in the time interval up to the first time point is greater than or equal to a predefined threshold value.
6. The battery cell replacement detection apparatus of clause 5, wherein the local extremum includes a peak of the first curve graph, and the processor is configured to:
   derive a horizontal axis position change amount and a vertical axis position change amount of the peak of the first curve graph as the first change amount based on a coordinate system in which the first curve graph is defined;
   derive a horizontal axis position change amount and a vertical axis position change amount of a peak of the second curve graph compared to the peak of the first curve graph obtained last in the time interval up to the first time point as the second change amount; and
   determine that the battery cell mounted in the battery pack has been replaced when a difference between the horizontal axis position change amount of the first change amount and the horizontal axis position change amount of the second change amount is greater than or equal to a first threshold value or when a difference between the vertical axis position change amount of the first change amount and the vertical axis position change amount of the second change amount is greater than or equal to a second threshold value.
7. The battery cell replacement detection apparatus of any of clauses 4 to 6, wherein the processor is configured to:
   obtain the first curve graph each time a charging and discharging cycle corresponding to a specific period in a time interval up to the first time point is completed and derive a third change amount for an interval of the local extremum of the first curve graph; and
   determine that the battery cell mounted in the battery pack has been replaced when a difference between the third change amount and a fourth change amount for an interval of the local extremum of the second curve graph compared to the interval of the local extremum of the first curve graph obtained last in the time interval up to the first time point is greater than or equal to a predefined threshold value.
8. The battery cell replacement detection apparatus of clause 7, wherein the local extremum includes a trough of the first curve graph, and the processor is configured to:
   derive an interval change amount of a trough of the first curve graph as the third change amount based on a coordinate system in which the first curve graph is defined;
   derive an interval change amount of a trough of the second curve graph compared to the trough of the first curve graph obtained last in the time interval up to the first time point as the fourth change amount; and
   determine that the battery cell mounted in the battery pack has been replaced when a difference between the interval change amount of the third change amount and the interval change amount of the fourth change amount is greater than or equal to the threshold value.
9. The battery cell replacement detection apparatus of any of clauses 4 to 8, wherein the local extremum includes a peak or trough of the first curve graph, and the processor is configured to determine that the battery cell mounted in the battery pack has been replaced when a number of peaks of the first curve graph is not equal to a number of peaks of the second curve graph or when a number of troughs of the first curve graph is not equal to a number of troughs of the second curve graph.
10. The battery cell replacement detection apparatus of any of clauses 4 to 9, wherein the processor is configured to:
   store the change behavior of the local extremum of the first curve graph in the memory for each temperature section of the battery cell; and
   extract the change behavior of the local extremum of the first curve graph corresponding to a current temperature of the battery cell from the memory during an operation for detecting whether the battery cell mounted in the battery pack has been replaced and detect whether the battery cell mounted in the battery pack has been replaced using the extracted change behavior of the local extremum of the first curve graph.
11. The battery cell replacement detection apparatus of any of clauses 4 to 10, wherein the first time point required for deriving the change behavior of the local extremum of the first curve graph is a time point after the battery cell has been subjected to a predefined number of charging and discharging cycles.
12. The battery cell replacement detection apparatus of any of clauses 2 to 11, wherein the first curve graph is an incremental capacity curve according to an incremental capacity analysis (ICA) or a differential voltage curve according to a differential voltage analysis (DVA).
13. The battery cell replacement detection apparatus of any preceding clause, wherein the processor is configured to enter a use prohibition mode that prohibits the use of the battery pack when it is determined that the battery cell mounted in the battery pack has been replaced.
14. The battery cell replacement detection apparatus of any preceding clause, wherein the processor is configured to enter a detection stop mode in which an operation for detecting whether the battery cell mounted in the battery pack has been replaced is not performed when a first flag signal is received and to release the detection stop mode when a second flag signal having a complementary value to the first flag signal is received.
15. A battery cell replacement detection method, comprising:
   performing, by a processor, charging and discharging of a battery cell mounted in a battery pack; and
   detecting, by the processor, whether the battery cell mounted in the battery pack has been replaced by analyzing changes in a unique characteristic parameter, that depends on at least one chemical characteristic of the battery cell, during a process in which the battery cell mounted in the battery pack is charged and discharged.
16. The battery cell replacement detection method of clause 15, wherein the unique characteristic parameter is a first curve graph defined by a ratio between a voltage change amount and a capacity change amount of the battery cell during the process in which the battery cell mounted in the battery pack is charged and discharged, and
   in the detecting, the processor detects whether the battery cell mounted in the battery pack has been replaced by analyzing changes in a local extremum of the first curve graph.
17. The battery cell replacement detection method of clause 16, wherein in the detecting, the processor is configured to detect whether the battery cell mounted in the battery pack has been replaced by determining whether a local extremum of a second curve graph obtained at a second time point that is temporally subsequent to a first time point matches a change behavior of the local extremum of the first curve graph derived from a result of analyzing the changes in the unique characteristic parameter during the process of charging and discharging the battery cell up to the first time point.
18. The battery cell replacement detection method of clause 17, wherein the local extremum includes a peak of the first curve graph; and
   in the detecting, the processor is configured to:
   obtain the first curve graph each time a charging and discharging cycle corresponding to a specific period in a time interval up to the first time point is completed and derive a first change amount for a position of the local extremum of the first curve graph; and
   determine that the battery cell mounted in the battery pack has been replaced when a difference between the first change amount and a second change amount for a position of the local extremum of the second curve graph compared to the position of the local extremum of the first curve graph obtained last in the time interval up to the first time point is greater than or equal to a predefined threshold value.
19. The battery cell replacement detection method of clause 17 or clause 18, wherein the local extremum includes a trough of the first curve graph; and
   in the detecting, the processor is configured to:
   obtain the first curve graph each time a charging and discharging cycle corresponding to a specific period in a time interval up to the first time point is completed and derive a third change amount for an interval of the local extremum of the first curve graph: and
   determine that the battery cell mounted in the battery pack has been replaced when a difference between the third change amount and a fourth change amount for an interval of the local extremum of the second curve graph compared to the interval of the local extremum of the first curve graph obtained last in the time interval up to the first time point is greater than or equal to a predefined threshold value.
20. The battery cell replacement detection method of any of clauses 17 to 19, wherein the local extremum includes a peak or trough of the first curve graph; and
   in the detecting, the processor is configured to determine that the battery cell mounted in the battery pack has been replaced when a number of peaks of the first curve graph is not equal to a number of peaks of the second curve graph or when a number of troughs of the first curve graph is not equal to a number of troughs of the second curve graph.

## Claims

1. A battery cell replacement detection apparatus, comprising:
a processor; and
a memory configured to store at least one command executed by the processor,
wherein the processor is configured to detect whether a battery cell mounted in a battery pack has been replaced by analyzing changes in a unique characteristic parameter, that depends on at least one chemical characteristic of the battery cell, during a process in which the battery cell mounted in the battery pack is charged and discharged.

2. The battery cell replacement detection apparatus of claim 1, wherein the unique characteristic parameter is a curve graph defined by a ratio between a voltage change amount and a capacity change amount of the battery cell during the process in which the battery cell mounted in the battery pack is charged and discharged.

3. The battery cell replacement detection apparatus of claim 2, wherein the processor is configured to detect whether the battery cell mounted in the battery pack has been replaced by analyzing changes in a local extremum of the first curve graph.

4. The battery cell replacement detection apparatus of claim 3, wherein the processor is configured to detect whether the battery cell mounted in the battery pack has been replaced by determining whether a local extremum of a second curve graph obtained at a second time point that is temporally subsequent to a first time point matches a change behavior of the local extremum of the first curve graph derived from a result of analyzing the changes in the unique characteristic parameter during the process of charging and discharging the battery cell up to the first time point.

5. The battery cell replacement detection apparatus of claim 4, wherein the processor is configured to:
obtain the first curve graph each time a charging and discharging cycle corresponding to a specific period in a time interval up to the first time point is completed and derive a first change amount for a position of the local extremum of the first curve graph; and
determine that the battery cell mounted in the battery pack has been replaced when a difference between the first change amount and a second change amount for a position of the local extremum of the second curve graph compared to the position of the local extremum of the first curve graph obtained last in the time interval up to the first time point is greater than or equal to a predefined threshold value.

6. The battery cell replacement detection apparatus of claim 5, wherein the local extremum includes a peak of the first curve graph, and the processor is configured to:
derive a horizontal axis position change amount and a vertical axis position change amount of the peak of the first curve graph as the first change amount based on a coordinate system in which the first curve graph is defined;
derive a horizontal axis position change amount and a vertical axis position change amount of a peak of the second curve graph compared to the peak of the first curve graph obtained last in the time interval up to the first time point as the second change amount; and
determine that the battery cell mounted in the battery pack has been replaced when a difference between the horizontal axis position change amount of the first change amount and the horizontal axis position change amount of the second change amount is greater than or equal to a first threshold value or when a difference between the vertical axis position change amount of the first change amount and the vertical axis position change amount of the second change amount is greater than or equal to a second threshold value.

7. The battery cell replacement detection apparatus of any of claims 4 to 6, wherein the processor is configured to:
obtain the first curve graph each time a charging and discharging cycle corresponding to a specific period in a time interval up to the first time point is completed and derive a third change amount for an interval of the local extremum of the first curve graph; and
determine that the battery cell mounted in the battery pack has been replaced when a difference between the third change amount and a fourth change amount for an interval of the local extremum of the second curve graph compared to the interval of the local extremum of the first curve graph obtained last in the time interval up to the first time point is greater than or equal to a predefined threshold value.

8. The battery cell replacement detection apparatus of claim 7, wherein the local extremum includes a trough of the first curve graph, and the processor is configured to:
derive an interval change amount of a trough of the first curve graph as the third change amount based on a coordinate system in which the first curve graph is defined;
derive an interval change amount of a trough of the second curve graph compared to the trough of the first curve graph obtained last in the time interval up to the first time point as the fourth change amount; and
determine that the battery cell mounted in the battery pack has been replaced when a difference between the interval change amount of the third change amount and the interval change amount of the fourth change amount is greater than or equal to the threshold value.

9. The battery cell replacement detection apparatus of any of claims 4 to 8, wherein the local extremum includes a peak or trough of the first curve graph, and the processor is configured to determine that the battery cell mounted in the battery pack has been replaced when a number of peaks of the first curve graph is not equal to a number of peaks of the second curve graph or when a number of troughs of the first curve graph is not equal to a number of troughs of the second curve graph.

10. The battery cell replacement detection apparatus of any of claims 4 to 9, wherein the processor is configured to:
store the change behavior of the local extremum of the first curve graph in the memory for each temperature section of the battery cell; and
extract the change behavior of the local extremum of the first curve graph corresponding to a current temperature of the battery cell from the memory during an operation for detecting whether the battery cell mounted in the battery pack has been replaced and detect whether the battery cell mounted in the battery pack has been replaced using the extracted change behavior of the local extremum of the first curve graph.

11. The battery cell replacement detection apparatus of any of claims 4 to 10, wherein the first time point required for deriving the change behavior of the local extremum of the first curve graph is a time point after the battery cell has been subjected to a predefined number of charging and discharging cycles.

12. The battery cell replacement detection apparatus of any of claims 2 to 11, wherein the first curve graph is an incremental capacity curve according to an incremental capacity analysis (ICA) or a differential voltage curve according to a differential voltage analysis (DVA).

13. The battery cell replacement detection apparatus of any preceding claim, wherein the processor is configured to enter a use prohibition mode that prohibits the use of the battery pack when it is determined that the battery cell mounted in the battery pack has been replaced.

14. The battery cell replacement detection apparatus of any preceding claim, wherein the processor is configured to enter a detection stop mode in which an operation for detecting whether the battery cell mounted in the battery pack has been replaced is not performed when a first flag signal is received and to release the detection stop mode when a second flag signal having a complementary value to the first flag signal is received.

15. A battery cell replacement detection method, comprising:
performing, by a processor, charging and discharging of a battery cell mounted in a battery pack; and
detecting, by the processor, whether the battery cell mounted in the battery pack has been replaced by analyzing changes in a unique characteristic parameter, that depends on at least one chemical characteristic of the battery cell, during a process in which the battery cell mounted in the battery pack is charged and discharged.
